Europäisches Patentamt

European Patent Office

Office européen des brevets

(11) Publication number: **0 451 644 A1**

# EUROPEAN PATENT APPLICATION

(21) Application number: 91105040.9

(22) Date of filing: 28.03.91

(51) Int. Cl.5: **H01L 23/485**, H01L 21/90, H01L 21/285, H01L 23/532

(30) Priority: 10.04.90 US 507281

(43) Date of publication of application:
16.10.91 Bulletin 91/42

(84) Designated Contracting States:
DE FR GB IT NL

(71) Applicant: TEXAS INSTRUMENTS INCORPORATED
13500 North Central Expressway
Dallas Texas 75265(US)

(72) Inventor: McPherson, Joe W.
5813 Pathfinder Trail
Plano, Texas 75093(US)
Inventor: Lawrence, John D.
12709 Burning Log Lane
Dallas, Texas 75243(US)

(74) Representative: Leiser, Gottfried, Dipl.-Ing. et al
Patentanwälte Prinz, Leiser, Bunke & Partner
Manzingerweg 7
W-8000 München 60(DE)

(54) An improved metallization system for reduced corrosion susceptibility.

(57) A metallization system for an integrated circuit is disclosed. This metallization includes a film of an alloy of aluminum, copper and silicon (16), which is sputtered onto the surface of a wafer having active semiconductor elements therein, to provide an interconnection. A barrier layer (14), for preventing the diffusion of metal atoms such as aluminum into the underlying silicon, can be provided under the aluminum alloy film (16). It has been observed that the presence of copper in aluminum metallization, while reducing the electromigration failure rate, increases the susceptibility of the aluminum film to corrosion. Doping the aluminum with silicon, in addition to the copper, has been observed to reduce the corrosion susceptibility of the aluminum alloy film.

Fig. 2

This invention is in the field of integrated circuits and, more specifically, is directed to metallization interconnection systems for semiconductor integrated circuits.

Background of the Invention

Due to both decreasing feature size and more stringent reliability goals, the requirements to be met by metallization systems in modern integrated circuits are quite significant. A first observed problem in aluminum metallization systems is commonly referred to as junction "spiking", where the local dissolution of silicon at the contact location allows aluminum atoms to diffuse into and through the doped region to which contact is desired. This problem is exaggerated in modern integrated circuits where the junction depth (as scaled for submicron circuits) is quite shallow, for example on the order of 0.2 microns. This shallow junction depth requires that any metallization system connecting to diffused regions must have minimal diffusion of metal atoms, such as aluminum, into the junction area.

Secondly, as the feature sizes of the metallization itself becomes small (for example, line widthS on the order of 2 microns or less), not only does the series resistance of the metallization system increase as the cross-sectional area of the metal line decreases, but the current density passing through the narrow metal line correspondingly increases. As is well known in the art, the electromigration failure rate of metal lines varies with approximately the square of the current density carried by the metal line. Accordingly, the narrow metal line widths required for modern integrated circuits causes additional concern relative to the electromigration failure rate.

Thirdly, the corrosion susceptibility of the metallization systems for integrated circuits is becoming a major concern for integrated circuit manufacturers. Integrated circuit metallization can be exposed to corrosive environments. An example of such an environment arises if the wafer is not sufficiently rinsed after HCl processing, so that a chlorine-containing residue remains. If the metallization is then exposed to moisture, for example if the chip is encapsulated in a plastic package, this moisture can activate the chlorine and, especially under electrical bias, electrolytic corrosion of the metallization can occur. As the chip size (relative to package size) increases for modern high-density circuits such as dynamic random access memories (dRAMs), the distance which moisture has to travel to reach a plastic-encapsulated chip is reduced. Accordingly, corrosion susceptibility is becoming an increasing concern for high density VLSI circuits.

The primary metallization material used in conventional integrated circuits is aluminum. Relative to the problem of junction spiking, one approach to the problem of junction spiking is to dope the aluminum used for metallization with silicon, for example using 1% silicon-doped aluminum as the sputtered or evaporated metal material. With such doping of the aluminum layer, the problem of junction spiking has been observed to be significantly reduced. It should be noted, however, that the addition of silicon dopant to the metal layer increases the series resistance of the metallization system. A second approach to the problem of junction spiking is the use of a barrier metal layer, examples of which include refractory metals such as tungsten, a psuedo alloy layer such as titanium-tungsten, a metal silicide, or other compounds such as titanium nitride. Such barrier layers prevent the diffusion of metal atoms into the junction region while still allowing for good ohmic contact between the metallization layer and the diffused region.

The problem of electromigration has been addressed by the use of copper-doped aluminum. At dopant levels in the aluminum metallization system such as 0.5% to 2.0%, copper has been observed to reduce the electromigration failure rate, due to reduced gran-boundary diffusivity. In addition, the copper doping has been observed to harden the aluminum film, making it more robust for purposes of wire bonding and other connection techniques.

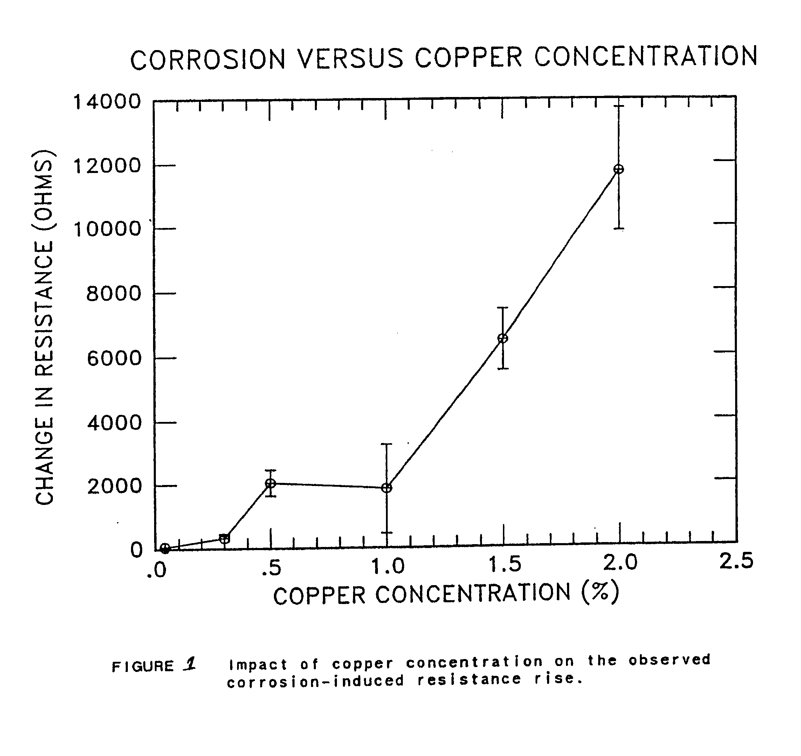

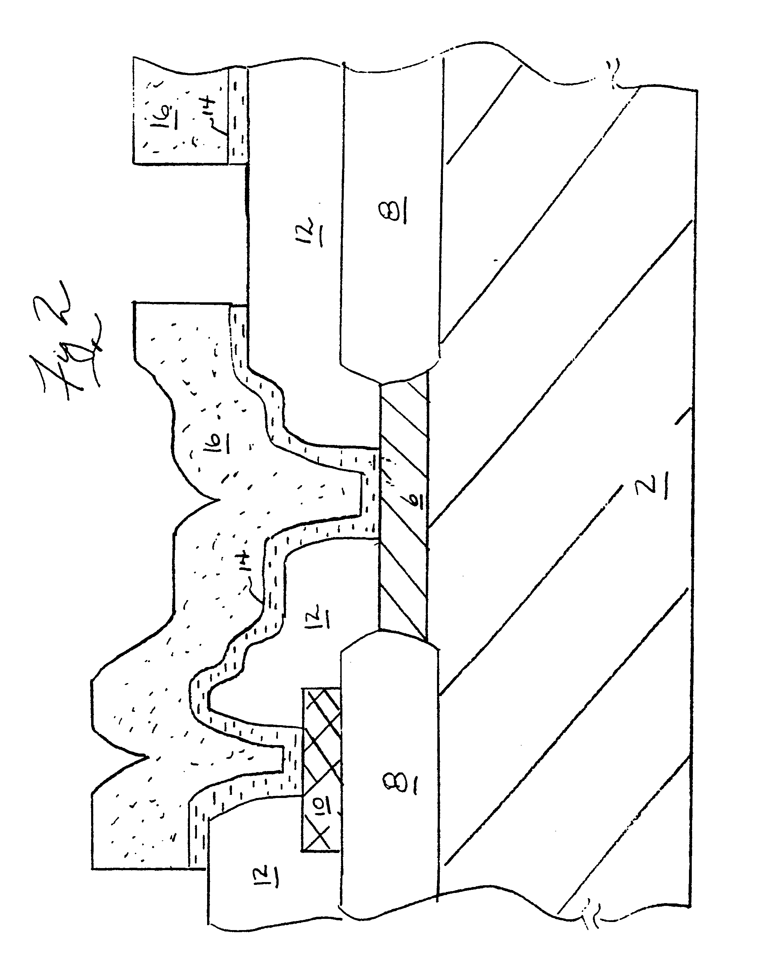

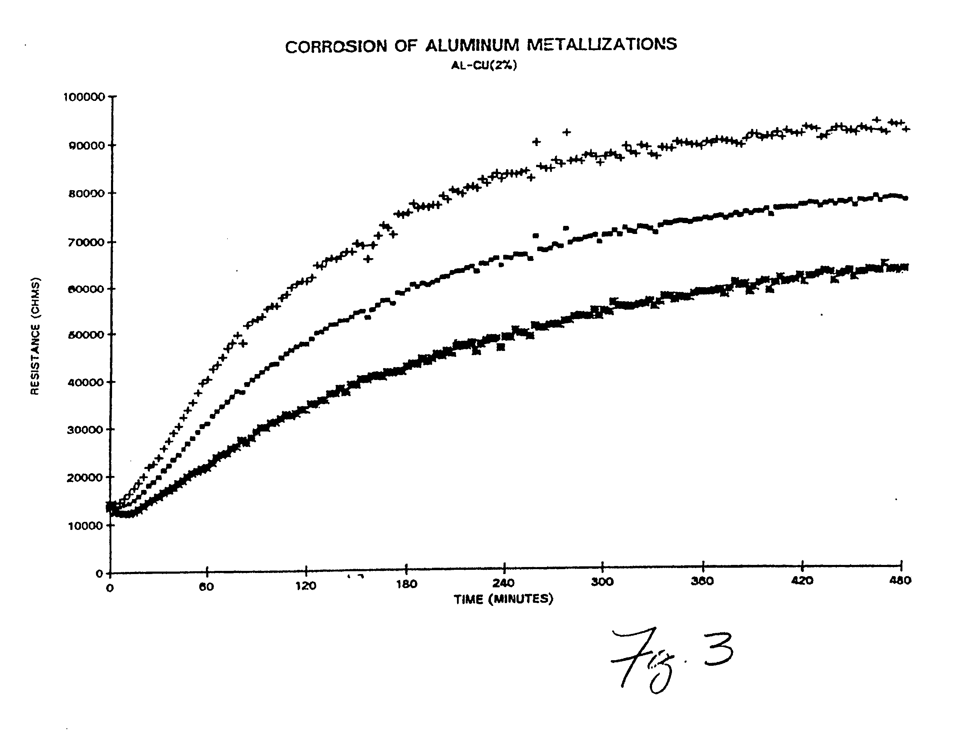

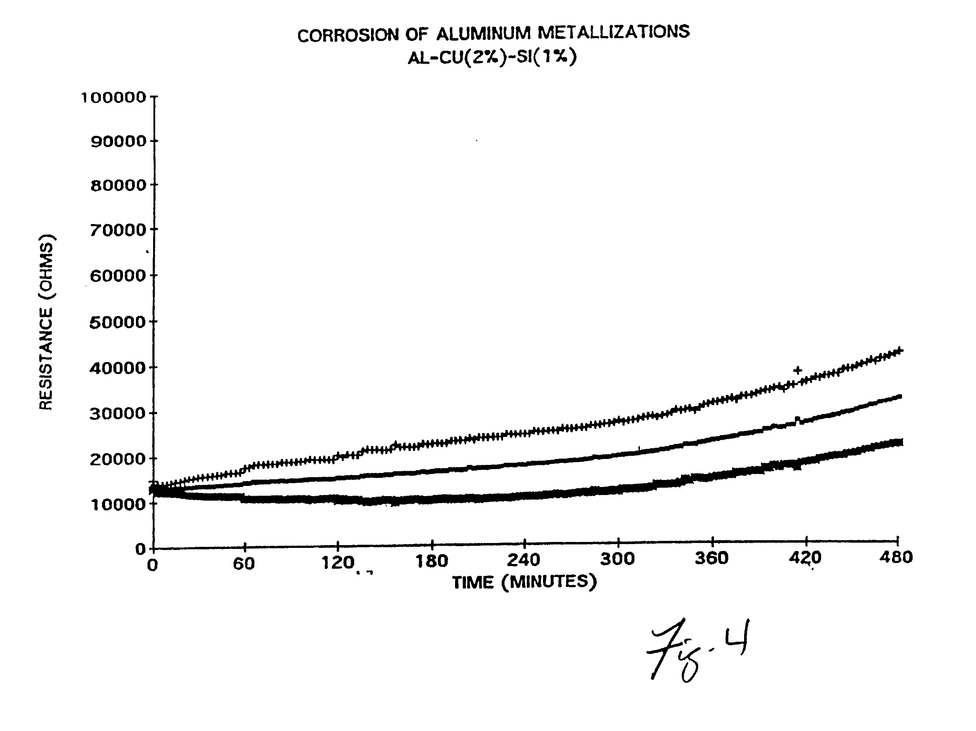

Accordingly, a conventional metallization system consists of copper-doped aluminum (with dopant levels on the range of 0.5% to 2.0%) overlying a barrier metal layer such as titanium-tungsten. Such a system addresses both the problems of electromigration (via the copper doping) and junction spiking (via the barrier metal). However, the presence of copper in the aluminum film has been observed to increase the corrosion susceptibility of the metallization due to galvanic effects. Referring to Figure 1, a graph of relative corrosion susceptibility is illustrated, indicating that increasing doping level of copper in the metallization layer corresponds, especially when beyond 1%, to an increase in the rate of corrosion. This characteristic leaves the integrated circuit manufacturer with making the undesired trade-off between corrosion susceptibility (by maintaining the copper concentration) and electromigration (by reducing the copper concentration).

In "A Wafer-Level Corrosion Susceptibility Test for Multilevel Metallization" by S.K.Fan and J.W. McPherson, 26th Annual Proceedings, International Reliability Physics Symposium 1988 (IEEE), pp. 50-57, incorporated herein by this reference, the enhanced corrosion of copper-doped aluminum overlying a titanium-tungsten barrier layer is observed. This paper, on page 56 relative to Figure 15, illustrates that a capping layer of either titanium-tungsten alloy or of 1% silicon-doped aluminum results in a reduction in the corrosion activity for 2% copper-doped aluminum. However, the addition of such a capping layer requires a more complex process, as either an additional sputtering or evaporation, or a dual-target sputtering apparatus, is required. In addition, since the capping layer is applied prior to metallization etch, the sides of the metal layer remain uncapped.

It is therefore an object of this invention to provide a metallization system with both improved electromigration performance and decreased corrosion susceptibility.

It is a further object of this invention to provide such a metallization system which susbstantially precludes junction spiking.

It is a further object of this invention to provide such a metallization system which, for the aluminum-based component, can be sputtered from a single target in a single step.

Other objects and advantages of this invention will be apparent to those of ordinary skill in the art having reference to the following specification in conjunction with the drawings.

## Summary of the Invention

The invention may be incorporated into an integrated circuit metallization system in an aluminum film which is both silicon-doped and copper-doped. Junction spiking may be further reduced by the presence of a barrier metal layer, underlying the silicon-doped copper-doped aluminum layer, of a refractory metal or alloy, for example titanium-tungsten. The metallization system can contact single-crystal silicon, polycrystalline silicon, or may be used as the upper metal level in a multi-level metallization system where the underlying metal is a refractory metal such as tungsten.

## Brief Description of the Drawings

Figure 1 is a graph showing the relative corrosion susceptibility of aluminum films, varying as a function of copper concentration.

Figure 2 is a cross-sectional diagram illustrating the metallization system of the first embodiment of the invention as incorporated into an integrated circuit.

Figure 3 is a graph illustrating the observed resistance over time for a copper-doped aluminum metallization system according to the prior art.

Figure 4 is a graph illustrating the observed resistance over time for a metallization system according to a first preferred embodiment of the invention.

Figures 5 and 6 are graphs illustrating the observed resistance over time for individual test units from the data graphed in Figures 3 and 4, respectively.

Figure 7 is a cross-sectional diagram illustrating the metallization system of a second embodiment of the invention as incorporated into an integrated circuit.

## Detailed Description of the Preferred Embodiments

Referring to Figure 2, a first embodiment of the invention is illustrated, as applied to a conventional integrated circuit structure of the MOS type. While the portions of the structure other than the metallization system will be described herein, it should be noted that they are shown for purposes of describing the context of the invention into which the metallization system of this invention may be used. Other conductivity types, and indeed other materials, can also take advantage of the benefits of the instant invention.

Substrate 2 is a p-type single crystal substrate having a surface at which the integrated circuits are formed. Region 6 is a doped region, for example n-type, which can serve as a diffused interconnection region, or an active region such as a source, drain, collector, base or emitter of a transistor. Field oxide 8 isolates portions of the surface of substrate 2 from one another, and is conventionally formed by way of local oxidation of silicon (LOCOS). Conductive electrode 10 overlies field oxide 8, and may be formed of polycrystalline silicon, as well as other materials such as refractory metals (e.g., tungsten, molybdenum, etc.), metal silicides, or other metals.

Dielectric film 12 overlies field oxide 8, doped region 6, and electrode 10 is dielectric film 12. Dielectric film 12 is often referred to as interlevel, or multilevel, dielectric or oxide, and conventionally consists of a deposited silicon oxide. Various types of deposited oxide are conventionally used for dielectric 12, including doped (phosphorous, arsenic, or boro-phosphorous doped glasses are conventional) and undoped oxides, either individually or in combination to form a stacked film. In addition, various spin-on glasses are now often used to form dielectric 12, generally in combination with one or more layers of conventionally deposited silicon dioxide. Such spin-on glasses are useful in providing a planar surface upon which the subsequent metallization is to be formed, thereby reducing problems with step coverage of the metal film. Contacts are then defined by way of conventional photolithography, and etched through dielectric film 12 to expose portions of electrode 10 and doped region 6 to which contact is to be made.

In this embodiment, a layer 14 of a barrier metal or alloy is first deposited over dielectric film 12, and in contact with those locations of electrode 10 and doped region 6 which are exposed after contact etch. An example of barrier layer 14 is a titanium-tungsten alloy having from 3% to 20% titanium by weight, for example 10% titanium. Other examples of barrier layer 14 include a refractory metal such as tungsten or molybdenum, a silicide film such as titanium silicide or molybdenum silicide, or other conductive metal compounds such as titanium nitride. The purpose of barrier layer 14, as is well known in the art, is to minimize the possibility of junction spiking. This occurs where metal atoms from the overlying metallization diffuse into the underlying silicon, for example in doped region 6, and not only making contact to the doped region 6 but also, if the metal diffusion extends through doped region 6, ohmically connecting doped region 6 to substrate 2. Such ohmic connection will likely cause the integrated circuit to be nonfunctional. Typical thicknesses for barrier layer 14, for example where Ti:W alloy is used, range from 200 nm to 500 nm.

Overlying barrier layer 14 in the embodiment of Figure 2 is metallization layer 16 constructed according to the invention. Metallization layer 16 is an aluminum alloy which is sputtered onto the surface of the wafer according to conventional techniques. Similarly as conventional aluminum alloys, layer 16 contains dopant levels of copper, for example ranging from 0.5% to 6%, as measured by weight in the sputtering target; as described above, the presence of copper in the aluminum alloy provides improved electromigration performance over aluminum films not containing copper. According to this embodiment of the invention, metal layer 16 also includes dopant levels of silicon. A preferred range of the dopant level of silicon, as measured by weight in the sputtering target, is from 0.1% to 3.0%, and preferably is on the order of 1% silicon. Accordingly, metallization film 16 is sputtered from a single target, this target containing both copper and silicon at dopant levels within aluminum bulk.

As will be described below relative to measured data, the presence of the silicon in copperdoped aluminum film 16 provides much improvement from the standpoint of corrosion susceptibility. The improvement in corrosion resistance is believed to be due to native silicon dioxide which forms on the surface of metallization layer 16, at its grain boundaries, or both, when silicon atoms are present in the film. While a native oxide forms over aluminum metal, the native oxide which is formed over silicon-doped aluminum is believed to be of greater integrity. This enhanced oxide further protects the aluminum metallization from any corrosive environment into which the circuit is placed, and is found to delay the time at which corrosion begins in such an environment.

As will be described below, the corrosion resistance of the film increases with the addition of silicon to the copper-doped aluminum film. However, it is known that the conductivity of the metallization of the film decreases with the amount of silicon doping in the film. Accordingly, the upper limit on the amount of silicon desired in the film depends upon the conductivity necessary for the completed film, i.e., one must trade off corrosion resistance with reduced metallization conductivity. As will be described hereinbelow, it has been found that a 1% doping level for silicon in the copperdoped aluminum film provides significant reduction in corrosion susceptibility, without significantly increasing the series resistance of the metallization film.

As discussed above, silicon doping in aluminum metallization has been utilized in order to reduce junction spiking; silicon doping is therefore common in metallization systems where no barrier layer is used. In the embodiment of Figure 2, it should be noted that the presence of barrier layer 14 eliminates the need for silicon doping in the metallization layer 16 for purposes of junction spiking prevention. Accordingly, conventional metallization systems using barrier layers have not included silicon in the aluminum alloy, since the barrier layer has prevented junction spiking and since, prior to this invention, it has been believed that silicon doping would only increase the series resistance of the metallization and not add any benefit. Furthermore, while silicon doping may harden a pure aluminum film, the addition of silicon to a copperdoped aluminum film would, at most, negligibly harden the film.

It should further be noted that the reduction in corrosion susceptibility will also be achieved from the use of silicon doping in copper-doped aluminum where no barrier layer 14 is present. Accordingly, the instant invention can be practiced without the use of barrier layer 14, and the silicon doping will not only reduce the corrosion susceptibility but also minimize junction spiking. The presence of copper doping in the film will also provide electromigration improvement over silicon-doped aluminum without copper therein. Accordingly, a metallization system consisting solely of copper and silicon doped aluminum, without a barrier layer 14 as shown in Figure 2, will provide good corrosion resistance, with reduced junction spiking and a reduced electromigration failure rate.

Referring to Figures 3 and 4, a comparison of the observed corrosion susceptibility of a metallization system according to a first preferred embodiment of the invention relative to a conventional metallization will be described. The graphs of Figures 3 and 4 plot the resistance over time of a metal serpentine structure, according to the test method described in the above-referenced paper by Fan and McPherson. For this test, the serpentine structure has a nominal metal width of 3.0 microns, and is 59.2 cm long.

For the test resulting in the data plotted in Figures 3 and 4, p-type wafers were first cleaned according to conventional cleanup processes to remove heavy and trace organic contaminants, particles and ionic contaminants. After cleanup, a 1 micron thick film of plasma silicon dioxide was deposited over the wafers at 300 degrees Celsius, so that the ensuing metallization layers would be insulated from the underlying silicon. After conventional cleanup, the wafers were split into two groups.

The first group, corresponding to the data plotted in Figure 3, received a 300 nm thick film of sputtered titanium-tungsten alloy onto the surface of the deposited oxide; this alloy included approximately 10% titanium. In situ with the Ti:W sputtering, this group then received a 600 nm thick film of sputtered aluminum, doped with 2% copper, according to conventional metallization systems.

The second group of wafers, corresponding to the data plotted in Figure 4, received the metallization according to this first preferred embodiment of the invention. These wafers first received a 300 nm thick film of Ti:W identically to the first group. In-situ with the Ti:W sputtering, the second group of wafers received a 600 nm thick film of a sputtered aluminum which included both copper doping and silicon doping. In this embodiment, the copper doping level in the target was 2%, and the silicon doping level was 1%.

Both groups of wafers were processed through conventional post-metal cleanups. The serpentine pattern described hereinabove and in the Fan and McPherson paper was imaged according to conventional photolithography with conventional positive photoresist processing. The aluminum alloy films for both groups were etched according to the pattern with a chlorine-based chemistry in a reactive ion etch (RIE) reactor, according to conventional metal etch technology. The barrier layer of Ti:W was etched in the same reactors using fluorine-based chemistry in RIE mode. No protective overcoat was applied to any of the wafers. Wafers from both groups were then diced, mounted into conventional ceramic side-brazed packages, and the serpentine patterns were wire-bonded to the package pins. No lids were applied to the packaged units.

As described in the Fan and McPherson paper, the use of a Ti:W barrier layer underlying the aluminum alloy metallization system allows quantitative electrical measurement of the rate at which the aluminum alloys corrode in a corrosive environment. For this experiment, each of the packaged units tested had a solution of ammonium chloride placed into the package in direct contact with the metallization; this solution will corrode aluminum alloys but not the Ti:W alloy. Since the Ti:W film has a much higher resistance than either aluminum alloy, at those locations at which the aluminum alloy is fully corroded, the current passing through the serpentine structure will be carried only by the Ti:W film. Therefore, a measurement of the serpentine structure resistance will indicate the extent of the serpentine structure which has the overlying aluminum alloy film corroded away.

It was also observed that the corrosion susceptibility of each of the films (i.e., both Cu-doped and Si-Cu-doped aluminum) is much reduced after the films are sintered, as is typical in conventional integrated circuit processes. Such sintering is commonly performed at 450 degrees celsius for 30 minuts. In order to better determine the relative corrosion rates of the two film types, the metallization for each of the two groups was not sintered for this test.

For the test which generated the data plotted in Figures 3 and 4, three drops of a 100 ppm ammonium chloride solution was placed into the cavities of each of the units under test. The sample size was twenty-four chips from each of the two wafer groups. To prevent evaporation of the corrosive solution during test, the units under test remained in a HAST accelerated test chamber at 100% RH and 25 degrees Celsius, under atmospheric pressure. The serpentine structure for each unit on test was connected, by way of MOSFET switching transistors, to a control computer, so that the resistance of each serpentine structure could be individually measured. During the test, no bias was applied to the serpentine structure except for the measurement of the resistance, which was done every three minutes.

Referring now to Figure 3, the corrosion performance of the conventional copper-doped aluminum film will now be discussed. The center line of Figure 3 shows the mean resistance for the twenty-four chips under test, while the upper and lower lines show plus and minus one standard deviations, respectively, for the observed data over time. As is evident from Figure 3, the nominal resistance for the serpentine structure with conventional 2% copper-doped aluminum is approximately 13 thousand ohms. The data shows that corrosion began for this metallization within the first thirty minutes, with the mean resistance reaching 50 thousand ohms at approximately 150 minutes into the test.

Figure 4 shows the corrosion performance of the group of units with metallization of 1% silicon and 2% copper doped aluminum. The nominal resistance at the beginning of the test for these structures was approximately the same as for the copper-only doped metallization, at approximately 13 thousand ohms. At the 150 minute point, the mean resistance for the twenty-four units under test having silicon and copper doped aluminum was approximately 15 thousand ohms. After the eight hour test was complete, the metallization system having silicon and copper doped aluminum indicated corrosion of a factor of six less than the corrosion of conventional copper-doped aluminum.

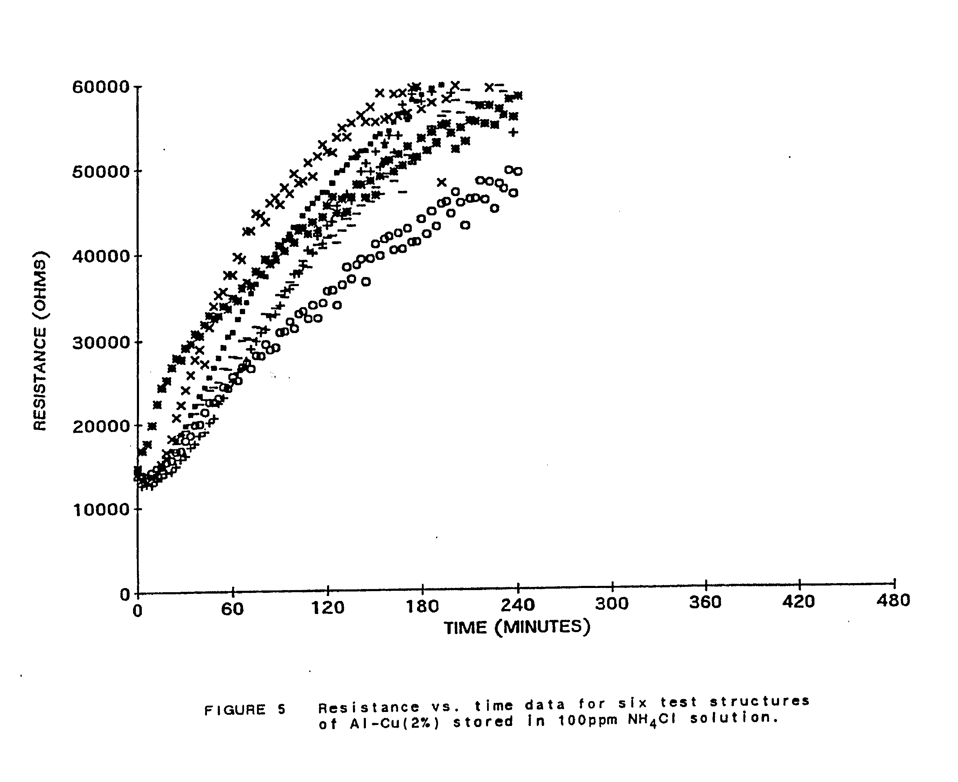

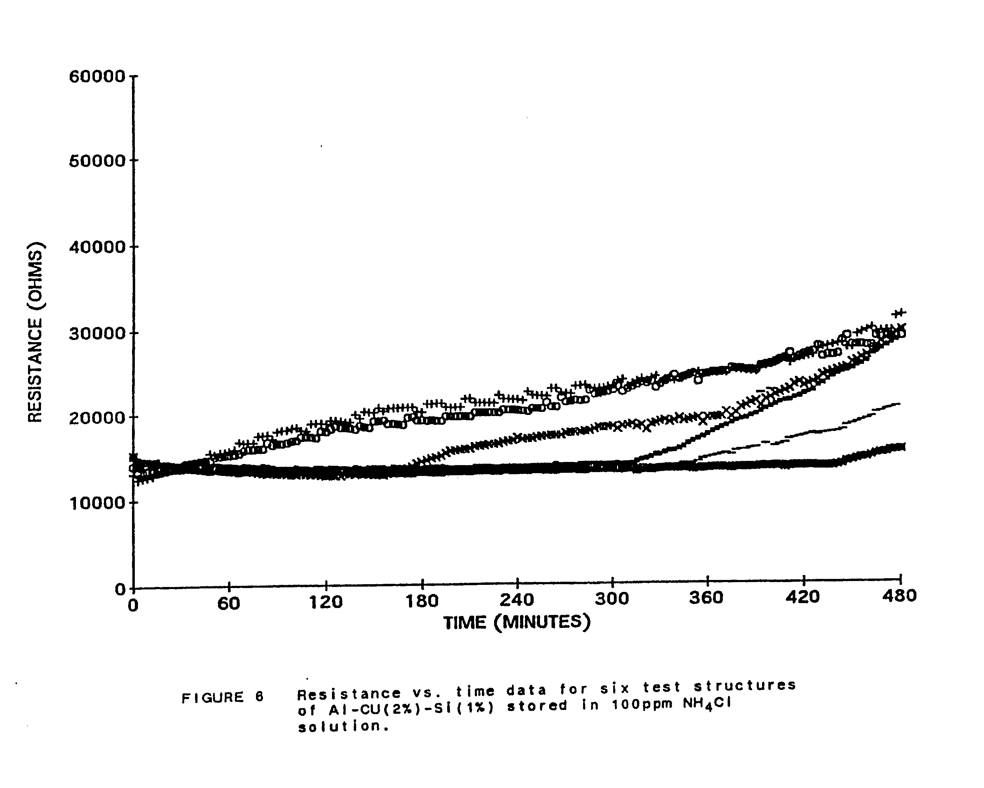

Figures 5 and 6 illustrate, in more detail, other results of this test. Figure 5 shows the resistance over time for each of six individual test structures having the conventional copper-doped aluminum metallization; Figure 6 similarly shows the resistance over time for each of six individual test structures having the above-described silicon and copper doped aluminum according to this embodiment of the invention. It can be observed, by comparing the resistance over time for the individual units of Figures 5 and 6, that the time rate of change of resistance varies significantly between the two metallization systems. As shown in Figure 5, all units having conventional copper-doped aluminum material began to corrode very quickly; in contrast, some units of the silicon and copper doped aluminum metallization did not begin to corrode until several hours had elapsed as shown in Figure 6. This behavior is believed to reflect the physical effect of the enhanced native oxide formed in the metallization according to the invention having both copper and silicon doping. The points in time at which corrosion begins (i.e., the resistance of individual units increases) in Figure 6 is believed to correspond to times at which the native oxide layer over the metallization is violated, at which time additional sites for corrosion are presented. So long as the native oxide layer remains intact, the metallization thereunder is believed to be substantially free from corrosion.

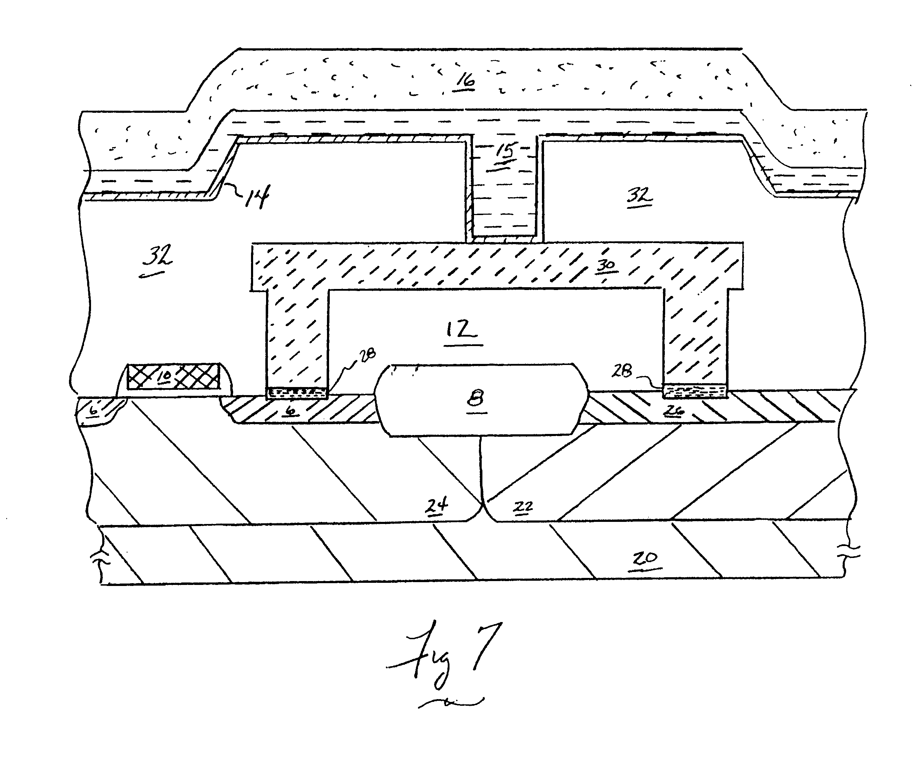

Referring now to Figure 7, a second application of the metallization system according to the invention will be described. Figure 7 illustrates a CMOS integrated circuit with multiple levels of metallization, as may be used in modern VLSI integrated circuits such as 16 Mbit dRAM devices. As in the structure of Figure 2, a p-type single crystal substrate 20 has the active circuits fabricated at a surface thereof. P-well 24 and n-well 22 are present at this surface, either formed at a surface of substrate 20 by way of ion implantation and diffusion thereinto, or similarly formed into an epitaxial layer grown over substrate 20. Field oxide structure 8 serves to isolate the surface of wells 22 and 24 from one another, and can also be used within a well 22 or 24 (not shown) for isolation of active regions therewithin. A conventional LDD n-channel transistor, having source/drain regions 6 and polysilicon gate electrode 10, is shown as present at the surface of p-well 24. An p-type doped region 26 is shown as present at the surface of n-well 22. Dielectric film 12 is then disposed over the surface of the structure, as in the case of the structure of Figure 2.

A first metallization layer 30 is used to contact doped regions 6 and 26. According to this embodiment, a layer of titanium metal is formed over the structure after contact etch, and the wafer is then heated in a nitrogen ambient, as described in U.S. Patent No. 4,545,116, issued October 8, 1985, assigned to Texas Instruments Incorporated and incorporated herein by this reference. This causes the formation of a titanium silicide film 28 at locations where the titanium metal is in contact with silicon; the remainder of the titanium film reacts with the nitrogen atmosphere to form a titanium nitride compound, which can be subsequently removed with a wet etch strip. It should be noted that titanium silicide film 28 can also be used at the locations of contacts to polysilicon, such as may be the case for electrode layer 10 at a location not shown and overlying field oxide 8. First level metallization 30 in this embodiment consists of tungsten, which is deposited by way of chemical vapor deposition (CVD), and is then patterned and etched according to conventional photolithography and etching techniques to define the contacts and interconnect layer 30 shown in Figure 7.

A second interlevel dielectric film 32 is then disposed over the surface of the wafer. Dielectric film 32 preferably consists of a first CVD oxide, for example TEOS oxide, followed by a layer of spin-on-glass. The spin-on-glass is then etched back and a second layer of TEOS oxide is then deposited thereover, and vias are formed therethrough by conventional photolithography and etching at the locations at which the upper metallization layer is to contact tungsten layer 30.

To form the metallization according to this embodiment of the invention, a sticking layer 14 of titanium-tungsten alloy is first sputtered to a thickness on the order of 50 nm, overall. This is followed by a layer 15 of CVD tungsten deposited overall to a thickness on the order of 350 nm. Aluminum alloy layer 16, as in the prior embodiment having copper and silicon at dopant levels, is then sputtered overall. Similarly as in the prior embodiment, the copper doping level preferably varies from 0.5% to 6.0%, more preferably at about 2.0%, and the silicon doping level is preferably within the range from 0.1% to 3.0%, more preferably at about 1.0%. After conventional photolithography and etching, the metal line consisting of sticking layer 14, tungsten layer 15 and copper and silicon doped aluminum layer 16, is defined to form the desired interconnection in the circuit.

Subsequent to the completion of the method described hereinabove, both for the case of Figure 2 and the case of Figure 7, a protective overcoat is generally formed over the structure by way of CVD. This protective overcoat consists of silicon nitride (preferably compressively stressed), silicon dioxide, or a combination of such films. After etching to expose the bond pads of the circuit, the wafer is generally electrically tested. In assembly, individual circuits are then separated from portions of the wafer, and external connections made thereto by way of wire bonding, direct bump connection, or the like, as is well known in the art. The individual circuits may then be packaged into a dual-in-line package, a chip carrier, or another type of package. An example of such a package is described in U.S. Patent No. 4,495,376 issued January 22, 1985, assigned to Texas Instruments Incorporated, and incorporated herein by this reference.

Although the invention has been described in detail herein with reference to its preferred embodiments, it is to be understood that this description is by way of example only, and is not to be construed in a limiting sense. It is to be further understood that numerous changes in the details of the embodiments of the invention, and additional embodiments of the invention, will be apparent to, and may be made by, persons of ordinary skill in the art having reference to this description. It is contemplated that such changes and additional embodiments are within the spirit and true scope of the invention as claimed below.

**Claims**

1. Metallization used for interconnections in a semiconductor integrated circuit, comprising:
   a first layer comprising a barrier metal; and
   a second layer overlying said first layer, comprising an alloy of aluminum, copper, and silicon.

2. The metallization of Claim 1, wherein the concentration of silicon in said alloy is within the range of 0.1% to 3.0% by weight.

3. The metallization of Claim 2, wherein the concentration of copper in said alloy is within the range of 0.5% to 6.0% by weight.

4. The metallization of Claim 3, wherein the concentration of copper in said alloy is about 2.0% by weight.

5. The metallization of Claim 3, wherein the concentration of silicon in said alloy is about 1.0% by weight.

6. The metallization of Claim 1, wherein the concentration of copper in said alloy is within the range of 0.5% to 6.0% by weight.

7. An integrated circuit formed at a semiconductor surface of a body, comprising:
   a plurality of conductive regions formed near said surface;
   a metallization film for interconnecting said plurality of conductive regions, said metallization film comprising an alloy of aluminum, copper and silicon; and
   a barrier layer disposed between said metallization film and one of said conductive regions.

8. The integrated circuit of Claim 7, further comprising a lower metal layer, in contact with said semiconductor surface of said body;
   wherein said metallization film is in contact with said lower metal layer.

9. The integrated circuit of Claim 7, wherein the concentration of copper in said metallization film is within the range of 0.5% to 6.0% by weight.

10. The integrated circuit of Claim 9, wherein the concentration of silicon in said metallization film is within the range of 0.1% to 3.0% by weight.

11. The integrated circuit of Claim 10, wherein the concentration of copper in said metallization film is about 2.0% by weight.

12. The integrated circuit of Claim 9, wherein the concentration of silicon in said metallization film is about 1.0% by weight.

13. The integrated circuit of Claim 7, wherein the concentration of silicon in said metallization film is within the range of 0.1% to 3.0% by weight.

14. A method of fabricating an integrated circuit at a semiconducting surface of a body, comprising:
   forming conductive regions near the surface of said body;
   forming an insulating layer over said conductive regions;
   removing selected portions of said insulating layer to expose portions of said conductive regions to which electrical contact is desired;
   depositing a barrier layer over said insulating film and in contact with said exposed portions of said exposed portions of said conductive regions; and

depositing a metallization layer comprising an alloy of aluminum, copper and silicon over said insulating layer so that electrical contact is made by said metallization layer to said exposed portions of said conductive regions through said barrier layer.

15. The method of Claim 14, wherein said step of depositing said metallization layer comprises sputtering from a target comprising an alloy of aluminum, copper and silicon.

16. The method of Claim 15, wherein the concentration of silicon in said target is within the range of 0.1% to 3.0% by weight.

17. The method of Claim 16, wherein the concentration of copper in said target is within the range of 0.5% to 6.0% by weight.

18. The method of Claim 17, wherein the concentration of copper in said target is about 2.0% by weight.

19. The method of Claim 18, wherein the concentration of silicon in said target is about 1.0% by weight.

20. The method of Claim 14, further comprising:
forming a lower metal layer overlying said insulating layer so that said lower metal layer makes electrical contact to said conductive regions;
forming a second insulating layer over said lower metal layer; and
removing selected portions of said second insulating layer at locations at which electrical contact is to be made with said lower metal layer;
wherein said barrier layer is in contact with said conductive regions by way of said lower metal layer.

CORROSION VERSUS COPPER CONCENTRATION

CHANGE IN RESISTANCE (OHMS)

COPPER CONCENTRATION (%)

FIGURE 1    Impact of copper concentration on the observed corrosion-induced resistance rise.

Fig. 2

CORROSION OF ALUMINUM METALLIZATIONS
AL-CU(2%)

Fig. 3

CORROSION OF ALUMINUM METALLIZATIONS
AL-CU(2%)-SI(1%)

*Fig. 4*

EP 0 451 644 A1

FIGURE 5    Resistance vs. time data for six test structures of Al-Cu(2%) stored in 100ppm NH$_4$Cl solution.

FIGURE 6   Resistance vs. time data for six test structures
of Al-CU(2%)-Sl(1%) stored in 100ppm NH₄Cl
solution.

EP 0 451 644 A1

Fig 7

EP 0 451 644 A1

European
Patent Office

**EUROPEAN SEARCH
REPORT**

Application Number

**EP 91 10 5040**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,A | EP-A-0 361 572   (N.V. PHILIPS GLOEILAMPEN-FABRIEKEN) <br> * column 2, line 34 - column 3, line 42; claims 8-10; figures 1-6 * <br> — — — | 1-19,20 | H 01 L 23/485 <br> H 01 L 21/90 <br> H 01 L 21/285 <br> H 01 L 23/532 |
| P,X,X | PATENT ABSTRACTS OF JAPAN vol. 14, no. 244 (E-932) 24 May 1990 <br> & JP-A-02068926 (SEIKO EPSON CORP.) 08 March 1990 <br> — — — | 1-4,6-11, 13-18,1-4 | |
| X,Y | PATENT ABSTRACTS OF JAPAN vol. 13, no. 564 (E-860) 14 December 1989, <br> & JP-A-01 235334 (OKI ELECTRIC IND. CO. LTD.) 20 September 1989, <br> * the whole document * <br> — — — | 1-3,5-10, 12-14,4, | |
| Y,A | PATENT ABSTRACTS OF JAPAN vol. 11, no. 046 (E-479) 12 February 1987, <br> & JP-A-61 208848 (TOSHIBA CORP.) 17 September 1986, <br> * the whole document * <br> — — — | 4,11, 15-19, 1-3,5- | |
| X,Y | PATENT ABSTRACTS OF JAPAN vol. 14, no. 045 (E-880) 26 January 1990, <br> & JP-A-01 276746 (SONY CORP.) 07 November 1989, <br> * the whole document * <br> — — — | 1,7,8,14, 2,3,6 | TECHNICAL FIELDS SEARCHED (Int. Cl.5) <br><br> H 01 L |
| Y,A | PATENT ABSTRACTS OF JAPAN vol. 13, no. 483 (E-839) 02 November 1989, <br> & JP-A-01 191448 (TOSHIBA CORP.) 01 August 1989, <br> * the whole document * <br> — — — | 2,3,6,9, 10,13,1 | |
| X,A | PATENT ABSTRACTS OF JAPAN vol. 8, no. 167 (E-258) 02 August 1984, <br> & JP-A-59 061945 (HITACHI SEISAKUSHO K.K.) 09 April 1984, <br> * the whole document * <br> — — — | 1,7,8,14, 2-5,9-1 | |

—/—

The present search report has been drawn up for all claims

| Place of search | Date of completion of search | Examiner |
|---|---|---|
| Berlin | 25 June 91 | KLOPFENSTEIN P R |

CATEGORY OF CITED DOCUMENTS

X : particularly relevant if taken alone
Y : particularly relevant if combined with another
    document of the same catagory
A : technological background
O : non-written disclosure
P : intermediate document
T : theory or principle underlying the invention

E : earlier patent document, but published on, or after
    the filing date
D : document cited in the application
L : document cited for other reasons
-------------------------------------------------------
& : member of the same patent family, corresponding
    document

# EUROPEAN SEARCH REPORT

**European Patent Office**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,A | PATENT ABSTRACTS OF JAPAN vol. 13, no. 232 (E-765) 29 May 1989, <br> & JP-A-01 037873 (HITACHI LTD.) 08 February 1989, <br> * the whole document * | 1,7,14 | |
| X,A | PATENT ABSTRACTS OF JAPAN vol. 10, no. 313 (E-448) 24 October 1986, <br> & JP-A-61 125048 (HITACHI LTD.) 12 June 1986, <br> * the whole document * | 1,7,14 | |
| X,A | PATENT ABSTRACTS OF JAPAN vol. 9, no. 277 (E-355) 06 November 1985, <br> & JP-A-60 119751 (HITACHI SEISAKUSHO K.K.) 27 June 1985, <br> * the whole document * | 1,7,14 . | |
| A | EP-A-0 269 095 (SIEMENS AG.) <br> * column 1, lines 1 - 28; figures 1-3 * | 1,7,8,14, 15,20 | |
| A | PATENT ABSTRACTS OF JAPAN vol. 4, no. 189 (E-039) 25 December 1980, <br> & JP-A-55 132056 (TOSHIBA CORP.) 14 October 1980, <br> * the whole document * | 1,7,8,14, 20 | TECHNICAL FIELDS SEARCHED (Int. Cl.5) |

The present search report has been drawn up for all claims

| Place of search | Date of completion of search | Examiner |
|---|---|---|
| Berlin | 25 June 91 | KLOPFENSTEIN P R |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document